# EUROPEAN PATENT APPLICATION

(11) **EP 0 677 750 A2**
(43) Date of publication of application: **18.10.1995**
(21) Application number: 95100268.2
(22) Date of filing: 10.01.1995
(51) Int. Cl.: G01R 33/09

(54) **A giant magnetoresistive sensor with an insulating pinning layer**

(30) Priority: 15.04.1994 US 228066
(71) Applicant: Hewlett-Packard Company, Palo Alto, California 94304 (US)
(72) Inventor: Anthony, Thomas C., Sunnyvale, California 94087 (US); Brug, James A., Menlo Park, California 94025 (US); Zhang, Shufeng, Tuxedo, New York 10987 (US)
(74) Representative: Schoppe, Fritz, Dipl.-Ing.

(57) **Abstract**

A magnetoresistive sensor system (200) including a sensor (100) that can achieve high magnetoresistances. The sensor (100) includes at least one insulating pinning layer (104). In a first embodiment, the sensor (100) is asymmetric with one insulating pinning layer (104) and one conducting pinning layer (116). In a second embodiment, the sensor (100) has two insulating pinning layers (104). In a third embodiment (150), there are more ferromagnetic layers than the first and the second embodiments. The third embodiment has at least one insulating pinning layer, with each ferromagnetic layer separated from another ferromagnetic layer by at least one non-magnetic layer. The insulating pinning layer (104) is preferably made of at least one layer of a material selected from the group including nickel oxide, cobalt oxide, nickel oxide-cobalt oxide alloys, and alpha-phase ferric oxide. The conducting pinning layer (116) is preferably made of at least one layer of a material selected from the group of manganese-iron, manganese-nickel, manganese-nickel-iron and a material with a coercivity much higher than the coercivity of at least one of the ferromagnetic layers in the sensor (100).

## Description

### BACKGROUND OF THE INVENTION

The present invention relates generally to magnetoresistive sensors and more particularly to magnetoresistive sensors based on the giant magnetoresistive effect.

Various devices have been invented for magnetoresistive sensors based on the giant magnetoresistive effect. A general discussion of the giant magnetoresistive effect can be found in US Patent Number 4,949,039, by Grunberg, titled, "Magnetic Field Sensor with Ferromagnetic Thin Layers Having Magnetically Anti-Parallel Polarized Components." A general discussion on one aspect of the giant magnetoresistive effect, known as the spin valve effect, can be found in US Patent Number 5,159,513 and US Patent Number 5,206,590, both by Dieny et al. and both titled, "Magnetoresistive Sensor Based on The Spin Valve Effect."

In another more recent reference titled, "Dual Spin Valve Magnetoresistive Sensor," US Patent Number 5,287,238, Baumgart et al. teach a magnetoresistive sensor with two spin valve sensors coupled together, one sensor being the mirror image of the other. The disclosed magnetoresistances are less than about 6 percent.

There is still a need for a magnetoresistive sensor with a high magnetoresistance.

### SUMMARY OF THE INVENTION

The present invention provides a magnetoresistive sensor that can achieve more than ten percent magnetoresistance.

In a first preferred embodiment, the sensor in a magnetoresistive sensor system has a substrate, an insulating pinning layer on the substrate, a first ferromagnetic layer on the insulating pinning layer, a first non-magnetic layer on the first ferromagnetic layer, a second ferromagnetic layer on the first non-magnetic layer, a second non-magnetic layer on the second ferromagnetic layer, a third ferromagnetic layer on the second non-magnetic layer, and a second pinning layer on the third ferromagnetic layer. Each pinning layer substantially pins the magnetization direction of its adjacent ferromagnetic layer. In this embodiment, the second pinning layer is a conducting pinning layer.

In a second preferred embodiment, the second pinning layer is also an insulating pinning layer.

In a third preferred embodiment, there are more ferromagnetic layers than the first and the second preferred embodiments. The third preferred embodiment has at least one insulating pinning layer, with each ferromagnetic layer separated from another ferromagnetic layer by at least one non-magnetic layer.

Each insulating pinning layer is made of one or more layers of a material selected from the group including nickel oxide, cobalt oxide, nickel oxide-cobalt oxide alloys (NiOₓCoO₁₋ₓ) and alpha-phase ferric oxide; and each conducting pinning layer is made of a material selected from the group including manganese-iron, manganese-nickel, manganese-nickel-iron and a material with a coercivity much higher than the coercivity of at least one of the ferromagnetic layers.

While the inventors not wishing the invention to be bound by theory, it is believed that at least a part of the advantageous results of the invention is obtained by having one or more insulating pinning layers. The use of an insulating pinning layer eliminates signal loss due to the shunting of current flowing through that pinning layer.

Other aspects and advantages of the present invention will become apparent from the following detailed description, which, when taken in conjunction with the accompanying drawings, illustrates by way of example the principles of the invention.

### BRIEF DESCRIPTION OF THE DRAWINGS

Figure 1 shows a preferred embodiment of the sensor in the present invention.

Figure 2 shows another preferred embodiment of the sensor in the present invention.

Figure 3 shows a preferred sensor system of the present invention.

Figure 4 shows a preferred example of the sensor in the present invention.

Figure 5 shows an example of the effect of the thicknesses of the non-magnetic layers on the exchange coupling fields acting on the second ferromagnetic layer in the present invention.

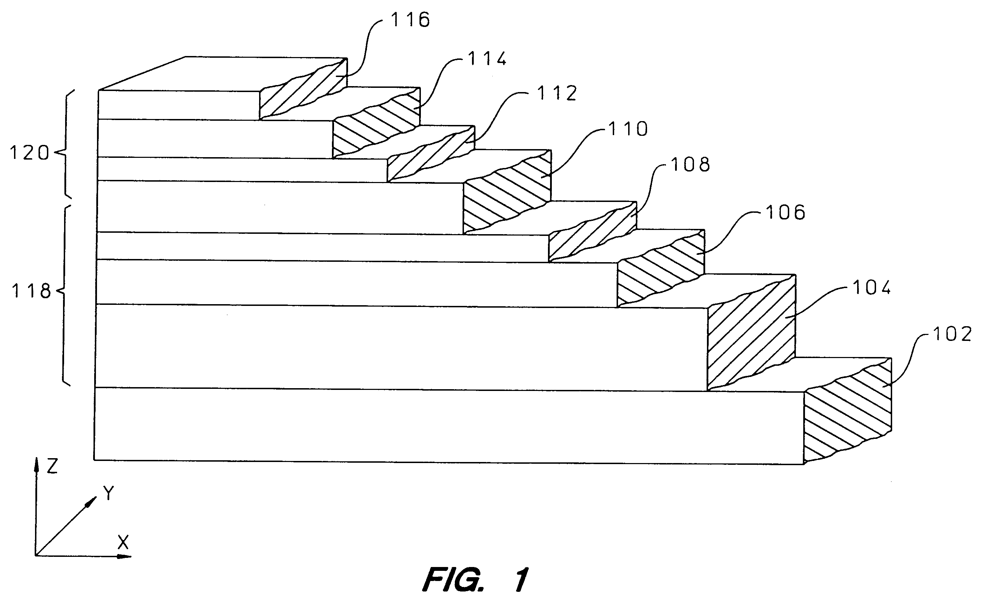

Same numerals in Figures 1-5 are assigned to similar elements in all the figures. Embodiments of the invention are discussed below with reference to Figures 1-5. However, those skilled in the art will readily appreciate that the detailed description given herein with respect to these figures is for explanatory purposes as the invention extends beyond these limited embodiments.

### DETAILED DESCRIPTION OF THE INVENTION

Figure 1 shows a first preferred embodiment of the sensor 100 in the present invention. The magnetoresistive sensor 100 includes a substrate 102, an insulating pinning layer 104 on the substrate 102, a first ferromagnetic layer 106 on the insulating pinning layer 104, a first non-magnetic layer 108 on the first ferromagnetic layer 106, a second ferromagnetic layer 110 on the first non-magnetic layer 108, a second non-magnetic layer 112 on the second ferromagnetic layer 110, a third ferromagnetic layer 114 on the second non-magnetic layer 112, and a second pinning layer 116 on the third ferromagnetic layer 114. The sensor 100 can be separated into a first spin valve 118 and a second spin valve 120, with each spin valve having about one half of the second ferromagnetic layer 110.

Each pinning layer substantially pins the magnetization direction of its adjacent ferromagnetic layer. For example, the insulating pinning layer 104 pins the magnetization direction of first ferromagnetic layer 106 to be substantially along the positive y direction; and similarly, the second pinning layer 116 pins the direction of the magnetization of the third ferromagnetic layer 114 also to be substantially along the positive y direction.

In the preferred embodiment, the second pinning layer 116 is a conducting pinning layer, and the sensor 100 is asymmetric because one pinning layer is insulating and the other pinning layer is conducting.

In the preferred embodiment, the magnetization orientation of the second ferromagnetic layer 110 is affected by a first exchange coupling field from the first ferromagnetic layer 106, and a second exchange coupling field from the third ferromagnetic layer 114. Exchange coupling fields will not be detailed here but are well-known to individuals skilled in the art. A detailed discussion of exchange coupling fields may be found in "Oscillatory Magnetic Exchange Coupling Through Thin Copper Layers," Parkin et al., Phys. Rev. Lett. 66, page 2152, 1991.

The thicknesses 128, 132 of the first 108 and the second 112 non-magnetic layers can be adjusted to control the effects of the first and the second exchange coupling fields on the second ferromagnetic layer 110.

In a second preferred embodiment of the present invention, the second pinning layer 116 is also an insulating pinning layer.

For the first and the second preferred embodiment, the magnetization direction of the second ferromagnetic layer 110 is preferably substantially perpendicular to the directions of magnetization of the first 106 and the third 114 ferromagnetic layers in the absence of an applied magnetic field. In one preferred embodiment, the magnetizations of the first 106 and the third 114 ferromagnetic layers are substantially in the same direction.

A third preferred embodiment of the present invention has more ferromagnetic layers than the first and the second preferred embodiments. Moreover, this embodiment has at least one insulating pinning layer, with each ferromagnetic layer separated from another ferromagnetic layer by at least one non-magnetic layer. The total number of ferromagnetic layers that are not pinned are two or more. Different thicknesses may be used for the numerous layers. One example of thicknesses for such numerous non-pinned layers with non-magnetic layers can be found in Parkin, supra.

In the third preferred embodiment, in one configuration, the number of ferromagnetic layers is odd, and the orientation of the magnetization direction of each ferromagnetic layer is about 180 degrees different from its adjacent ferromagnetic layers in the absence of an applied magnetic field. In another configuration, the orientation of the magnetization directions of two ferromagnetic layers closest to at least one pinning layer are substantially parallel; under that condition, out of the many ferromagnetic layers, the orientations of the magnetization directions of adjacent ferromagnetic layers other than the two ferromagnetic layers closest to that pinning layer should preferably be substantially anti-parallel in the absence of an applied magnetic field.

The second pinning layer in the third preferred embodiment can again be conducting or insulating, as in the first and the second preferred embodiments.

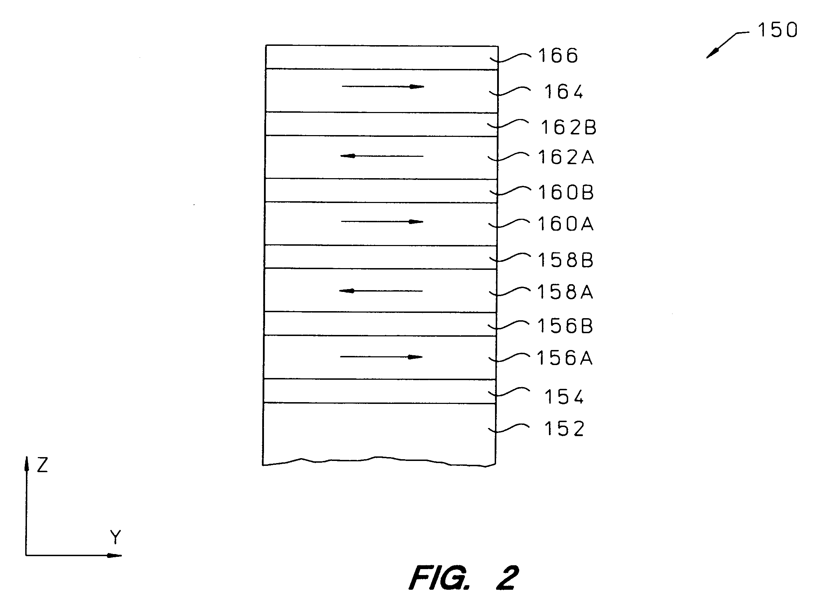

Figure 2 shows one example 150 of a sensor in the third preferred embodiment. It is again built on a substrate 152. An insulating pinning layer 154 is on the substrate 152. A first ferromagnetic layer 156A and a non-magnetic layer 156B are on the insulating pinning layer 154. The direction of the orientation of the magnetization of the first ferromagnetic layer 156A is pinned by the pinning layer to be substantially along the Y direction. A second ferromagnetic layer 158A and a non-magnetic layer 158B are on the first non-magnetic layer 156B. The direction of the orientation of the magnetization of the second ferromagnetic layer 158A is substantially along the negative Y direction in the absence of an applied magnetic field. A third ferromagnetic layer 160A and a non-magnetic layer 160B are over the second non-magnetic layer 158B. The direction of the orientation of the magnetization of the third ferromagnetic layer 160A is substantially along the Y direction in the absence of an applied magnetic field. A fourth ferromagnetic layer 162A and a non-magnetic layer 162B are over the third non-magnetic layer 160B. The direction of the orientation of the magnetization of the fourth ferromagnetic layer 162A is substantially along the negative Y direction in the absence of an applied magnetic field. A fifth ferromagnetic layer 164 and a second pinning layer 166 are over the fourth non-magnetic layer 162B. The direction of the orientation of the magnetization of the fifth ferromagnetic layer 160A is pinned by the second pinning layer 166 to be substantially along the Y direction.

In the preferred embodiments, each pinning layer establishes a preferred direction of the orientation of the magnetization of its adjacent ferromagnetic layer or pinned layer. This renders the magnetization direction of the pinned layer to be substantially insensitive to an applied field.

The insulating pinning layer is preferably an oxide layer, and is preferably made of one or more layers of a material selected from the group including nickel oxide, cobalt oxide, nickel oxide-cobalt oxide alloys, and alpha-phase ferric oxide.

The conducting pinning layer is preferably a metallic layer with a sufficiently high resistivity as compared to other non-pinning layers on the substrate. The conducting pinning layer is preferably made of one or more layers of a material selected from the group including manganese-iron, manganese-nickel, manganese-nickel-iron and a material with a coercivity much higher than the coercivity of at least one of the ferromagnetic layers. If the conducting pinning layer is made of a material selected from the group including manganese-iron, manganese-nickel and manganese-nickel-iron, the pinning layer is preferably covered by a capping layer made of a material, such as tantalum, to protect the pinning layer from oxidation.

Each ferromagnetic layer is preferably made of one or more layers of a material selected from the group including nickel, iron, cobalt and binary and ternary alloys made of these elements (NiₓFe_{y}Co_{1-x-y}). Each non-magnetic layer is preferably made of one or more layers of a material selected from the group including copper, silver, gold and alloys of copper, silver or gold.

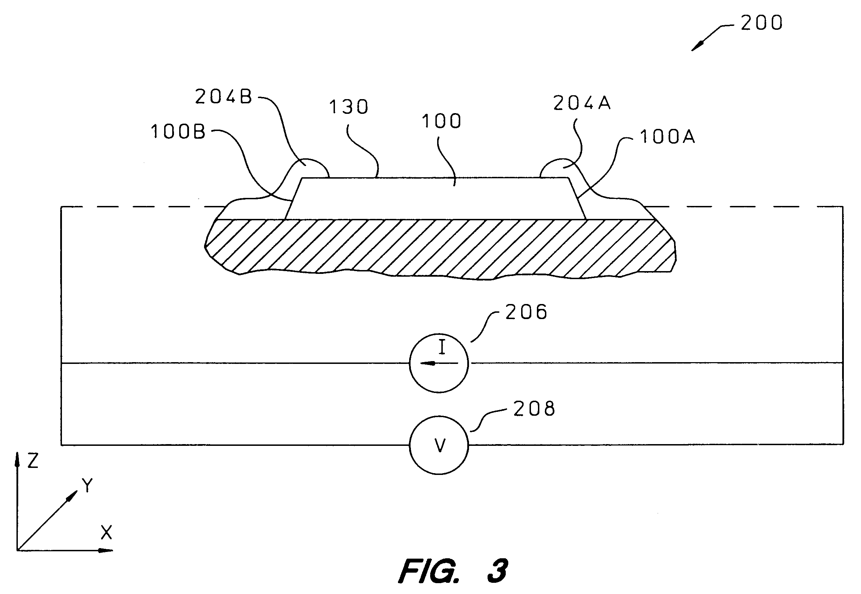

Figure 3 shows a preferred magnetoresistive sensor system 200, including a current source 206 coupling to the two ends, 100A and 100B, of the sensor 100. The sensor 100 can be replaced by the sensor 150 in the third preferred embodiment. The current source 206 controls a current flowing through at least a part of the sensor 100. The two ends, 100A and 100B, of the sensor 100 are connected to two electrical contacts, 204A and 204B, which, in turn, are connected to the current source 206.

The system 200 also includes a voltmeter 208, which is coupled to the sensor 100 for measuring the voltage across at least a part of the sensor 100 where the current flows through.

With the current source 206 and the voltmeter 208 in the system 200, when an applied magnetic field rotates the magnetization of the second ferromagnetic layer 110 changing the resistance of the sensor, the change can be measured by the voltmeter 208.

In the preferred embodiments, the two electrical contacts 204A and 204B can be positioned on top 130 of the sensor if the second pinning layer is conducting. If the second pinning layer is insulating, the two contacts can go through via-holes to make electrical connections. The two contacts are spaced apart so that the voltmeter 208 can measure the magnetoresistance of the sensor 100.

In another configuration for the preferred embodiments, the two electrical contacts 204A and 204B can be positioned at the two ends, 100A and 100B, of the sensor 100. In one of those configurations, the two ends, 100A and 100B, of the sensor preferably form obtuse angles with the top surface 130, as shown in Figure 3. The obtuse angles further enhance electrical connections between each end and its corresponding electrical contact, such as between 100B and 204B. The electrical contacts may be constructed by thin-film deposition techniques.

### Working Examples

The invention will be further clarified by a consideration of the following example, which is intended to be purely exemplary of using the invention.

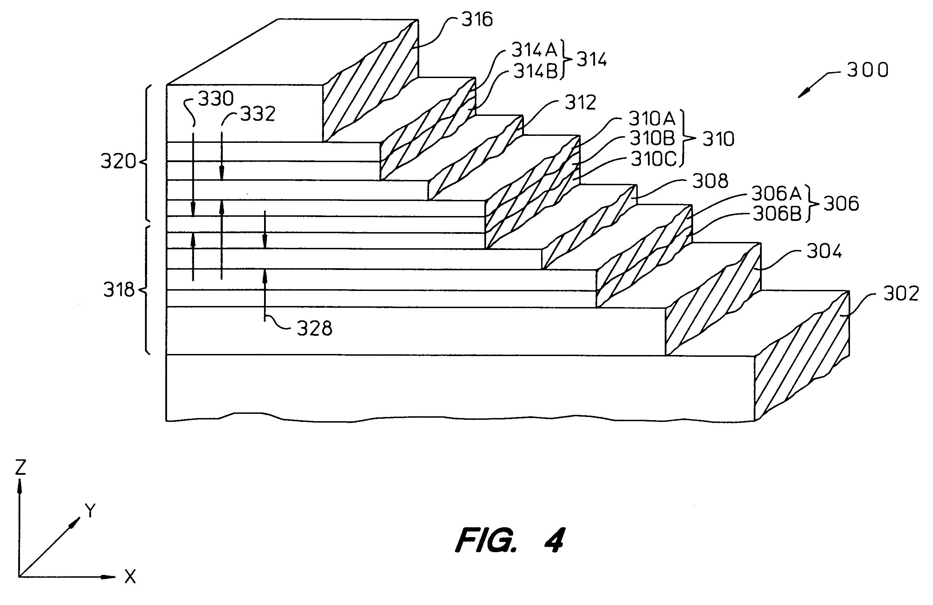

Figure 4 shows an asymmetric magnetoresistive sensor 300 of the present invention with a magnetoresistance of more than 10%. The sensor 300 is built on a substrate 302 with its surface covered by silicon dioxide. The first pinning layer 304 is an insulating pinning layer of nickel oxide and is about 75 nm thick positioned on top of the silicon dioxide. The first ferromagnetic layer 306 is made of two ferromagnetic layers--a nickel iron layer 306B of about 3 nm thick on top of the first pinning layer 304, and a cobalt layer 306A of about 2 nm thick on top of the nickel iron layer 306B. The first non-magnetic layer 308 is made of copper and is about 3.4 nm thick positioned on top of the first ferromagnetic layer 306.

The second ferromagnetic layer 310 is made of three ferromagnetic layers--a cobalt layer 310C of about 2 nm thick on top of the first non-magnetic layer 308, a nickel iron layer 310B between 0 to 10 nm thick on top of the cobalt layer 310C, and a cobalt layer 310A of about 2 nm thick on top of the nickel iron layer 310B. The layers 304, 306, 308, 310C and about one half of 310B form the first spin valve 318.

The second non-magnetic layer 312 is made of copper of about 2.4 nm thick positioned on top of the second ferromagnetic layer 310. The third ferromagnetic layer 314 is again made of two ferromagnetic layers--a cobalt layer 314B of about 2 nm thick on top of the second non-magnetic layer 312, and a nickel iron layer 314A of about 3 nm thick on top of the cobalt layer 314B. The conducting pinning layer 316 is made of manganese iron of about 15 nm thick positioned on top of the third ferromagnetic layer 314. The layers 316, 314, 312, 310A, and about one half of 310B form the second spin valve 320. Note that the manganese iron pinning layer 316 is preferably covered by a capping layer, such as tantalum, to protect the pinning layer from oxidation.

In the above example, with the thickness 330 of the nickel iron layer 310B in the second ferromagnetic layer 310 being about 4 nm, the magnetoresistance of the sensor 300 is about 11%. The magnetoresistance of the sensor 300 can be changed, for example, by changing the thickness of the nickel iron layer 310B.

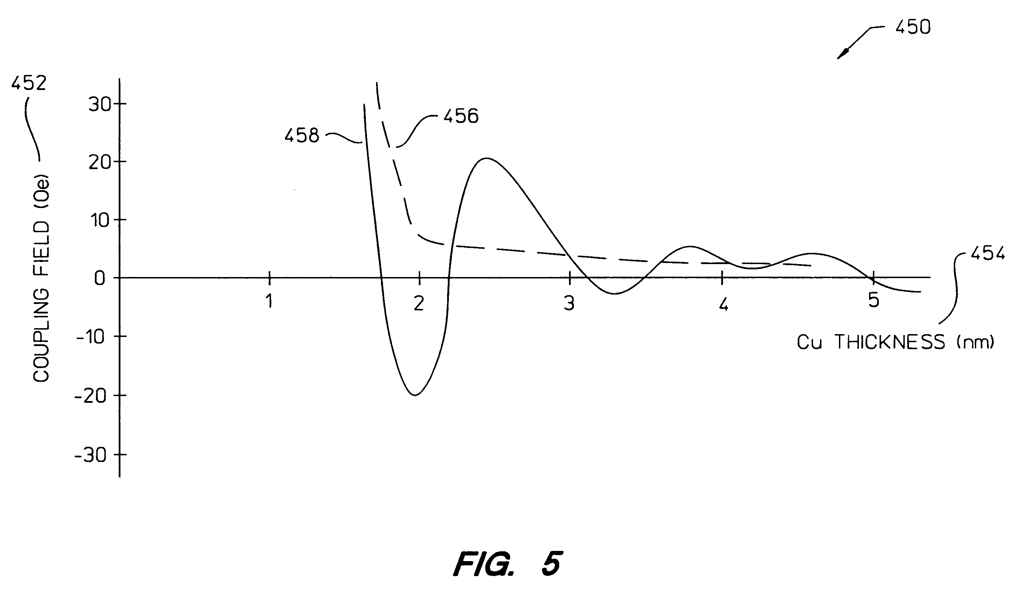

Figure 5 shows an example 450 of the effect of the thicknesses of the non-magnetic layers on the exchange coupling fields acting on the second ferromagnetic layer 310. In this example 450, the trace 458 denotes the exchange coupling field of the first spin valve 318 on the substrate 302, without the second spin valve 320. The trace 456 denotes the exchange coupling field of the second spin valve 320, without the first spin valve 318. For the trace 456, the second spin valve is positioned on the substrate 302. In other words, about one half of the second ferromagnetic layer 310 is on the substrate 302; the non-magnetic layer 312 is on the second ferromagnetic layer 310; the third ferromagnetic layer 314 is on the non-magnetic layer 312; and the conducting pinning layer 316 is on the third ferromagnetic layer 314.

Figure 5 shows that the exchange coupling field of the first spin valve 318 oscillates from having a positive coupling field or ferromagnetism to having a negative coupling field or anti-ferromagnetism. The oscillation depends on the thickness of the non-magnetic layer 308. However, the exchange coupling field of the second spin valve 320 does not exhibit ferromagnetic-antiferromagnetic oscillation. Thus, if one combines the effect of the first and the second spin valves, one can adjust the thicknesses of the first and the second non-magnetic layers to tailor the effect of the sum of the first and the second exchange coupling fields. In one preferred embodiment, the thicknesses 328, 332 of the first and the second non-magnetic layers 308, 312 are adjusted so as to minimize the effect of the sum of the first and the second exchange coupling fields.

From the foregoing it should be appreciated that a giant magnetoresistive sensor with at least one insulating pinning layer has been invented. The invented sensor can be used in magnetoresistive recording heads, such as in a tape drive or a disk drive. The invented sensor can also be used in a magnetic field sensing devices or instruments. Common mechanisms to make a tape drive or a disk drive or a magnetic field sensing device or instrument are obvious to those with ordinary skill in the art, and will not be further described in this application.

Other embodiments of the invention will be apparent to those skilled in the art from a consideration of this specification or practice of the invention disclosed herein. It is intended that the specification and examples be considered as exemplary only, with the true scope and spirit of the invention being indicated by the following claims.

## Claims

1. A magnetoresistive sensor system (200) comprising a sensor (100), the sensor comprising:
a substrate (102);
an insulating pinning layer (104) on the substrate (102);
a first ferromagnetic layer (106) on the insulating pinning layer (104);
a first non-magnetic layer (108) on the first ferromagnetic layer (106);
a second ferromagnetic layer (110) on the first non-magnetic layer (108);
a second non-magnetic layer (112) on the second ferromagnetic layer (110);
a third ferromagnetic layer (114) on the second non-magnetic layer (112); and
a second pinning layer (116) on the third ferromagnetic layer (114);
such that each pinning layer substantially pins the direction of magnetization of its adjacent ferromagnetic layer.

2. A sensor (100) as recited in Claim 1 wherein:
the second pinning layer (116) is a conducting pinning layer.

3. A sensor (100) as recited in Claim 1 wherein the second pinning layer (116) is an insulating pinning layer.

4. A sensor (100) as recited in Claims 2 or 3 wherein the insulating pinning layer (104) is an oxide layer.

5. A sensor (100) as recited in Claim 4 wherein the insulating pinning layer (104) is made of at least one layer of a material selected from the group including nickel oxide, cobalt oxide, nickel oxide-cobalt oxide alloys and alpha-phase ferric oxide.

6. A sensor (100) as recited in Claim 2 wherein the conducting pinning layer (116) is made of at least one layer of a material selected from the group including manganese-iron, manganese-nickel, manganese-nickel-iron and a material with a coercivity much higher than the coercivity of at least one of the ferromagnetic layers.

7. A sensor (100) as recited in Claim 2 wherein:
the magnetization orientation of the second ferromagnetic layer (110) is affected by a first exchange coupling field from the first ferromagnetic layer (106) and a second exchange coupling field from the third ferromagnetic layer (114); and
the thicknesses of the first (108) and the second (112) non-magnetic layers are adjusted to tailor the effect of the first and the second exchange coupling fields on the second ferromagnetic layer (110).

8. A sensor (100) as recited in Claim 6 wherein the thicknesses of the first (108) and the second (112) non-magnetic layers are adjusted to minimize the effects of the sum of the first and the second exchange coupling fields on the second ferromagnetic layer (110).

9. A sensor (100) as recited in Claims 1, 2 or 3, wherein each ferromagnetic layer (110) is made of at least one layer of a material selected from the group including nickel, iron, cobalt and binary and ternary alloys made of these three elements

10. A sensor (100) as recited in Claims 1, 2 or 3, wherein each non-ferromagnetic layer (108) is made of at least one layer of a material selected from the group including copper, silver, gold and alloys of copper, silver or gold.

11. A system (200) as recited in Claims 1, 2 or 3, wherein:
the second pinning layer (116) has a top surface (130);
the sensor (100) has two ends (100A, 100B), with each end forming an obtuse angle with the top surface (130); and
the system (200) further comprises a current source (206) connected to the two ends (100A, 100B);
such that the obtuse angles enhance the connections of the current source (206) to the two ends (100A, 100B).

12. A system (200) as recited in Claim 1 wherein the system is a magnetic field sensing device, a tape drive or a disk drive.

13. A sensor (150) as recited in Claims 1, 2 or 3 further comprising a plurality of ferromagnetic and a non-magnetic layers in between the second ferromagnetic layer and the second non-magnetic layer, such that each ferromagnetic layer is separated from another ferromagnetic layer by at least one non-magnetic layer.
